# EUROPEAN PATENT APPLICATION

(11) **EP 1 956 658 A2**
(43) Date of publication of application: **13.08.2008**
(21) Application number: 08151080.2
(22) Date of filing: 05.02.2008
(51) Int. Cl.: H01L 31/032, H01L 31/09, H01L 31/18

(54) **Ferroelectric infrared sensors and methods for their manufacturing**

(30) Priority: 06.02.2007 US 671662
(71) Applicant: Delphi Technologies, Inc., Troy, Michigan 48007 (US)
(72) Inventor: Chang, Shih-Chia, Bloomfield Hills, MI 48304 (US); Mantese, Joseph V., Shelby Township, MI 48315 (US)
(74) Representative: Denton, Michael John

(57) **Abstract**

Infrared sensors and methods for manufacturing the infrared sensors are provided. In one exemplary embodiment, the method includes depositing a germanium layer (204) on a silicon substrate (202). The method further includes depositing a first electrically conductive layer (208) on both the germanium layer (204) and a portion of the silicon substrate (202). The method further includes depositing a ferroelectric layer (210) on the first electrically conductive layer (208) opposite the germanium layer (204). The method further includes depositing a second electrically conductive layer (212) on both the ferroelectric layer (210) and a portion of the silicon substrate (202). The method further includes removing the germanium layer (204) by applying a liquid on the germanium layer (204) that dissolves the germanium layer (204) such that a cavity (206) is formed between the first electrically conductive layer (208) and the silicon substrate (202).

## Description

### TECHNICAL FIELD

This application relates to infrared sensors and methods for manufacturing the infrared sensors.

### BACKGROUND OF THE INVENTION

Infrared sensors have been developed that detect infrared energy. However, a disadvantage associated with existing infrared sensors is that the sensors are not fabricated using integrated circuit "IC" compatible processes. Thus, manufacturers have not manufactured monolithic infrared sensors and peripheral ICs on the same chip.

Accordingly, the inventors herein have recognized a need for an improved fabrication method for infrared sensors to overcome the above-identified shortcomings.

### SUMMARY OF THE INVENTION

A method for manufacturing an infrared sensor in accordance with an exemplary embodiment is provided. The method includes depositing an electrically insulative layer on a silicon substrate. The method further includes

depositing a germanium layer proximate to electrically insulative layer. The method further includes depositing a silicon nitride layer on a side of the germanium layer opposite the electrically insulative layer. The method further includes depositing a titanium layer on the silicon nitride layer. The method further includes disposing an infrared sensing structure on the titanium layer. The method further includes removing the germanium layer by applying a liquid on the germanium layer that dissolves the germanium layer such that a cavity is formed between the electrically insulative layer and the silicon nitride layer, the cavity configured to capture a portion of infrared energy therein that is received by the infrared sensing structure.

An infrared sensor in accordance with another exemplary embodiment is provided. The infrared sensor includes a silicon substrate. The infrared sensor further includes an electrically insulative layer disposed on the silicon substrate. The infrared sensor further includes a silicon nitride layer disposed proximate to the electrically insulative layer such that a cavity is formed therebetween. The infrared sensor further includes a titanium layer disposed on a side of the silicon nitride layer opposite the electrically insulative layer. The infrared sensor further includes an infrared sensing structure disposed on the titanium layer configured to generate a signal indicative of an amount of infrared energy being received by the infrared sensing structure. The cavity is configured to capture a portion of the infrared energy that is received by the infrared sensing structure.

A method for manufacturing an infrared sensor in accordance with another exemplary embodiment is provided. The method includes depositing an electrically insulative layer on a silicon substrate. The method further includes depositing a germanium layer proximate to the electrically insulative layer. The method further includes depositing a titanium layer on the germanium layer. The method further includes disposing an infrared sensing structure on the titanium layer. The method further includes removing the germanium layer by applying a liquid on the germanium layer that dissolves the germanium layer such that a cavity is formed between the electrically insulative layer and the titanium layer. The cavity is configured to capture a portion of infrared energy therein that is received by the infrared sensing structure.

An infrared sensor in accordance with another exemplary embodiment is provided. The infrared sensor includes a silicon substrate. The infrared sensor further includes an electrically insulative layer disposed on the silicon substrate. The infrared sensor further includes a titanium layer disposed proximate to the electrically insulative layer such that a cavity is formed therebetween. The infrared sensor further includes an infrared sensing structure disposed on the titanium layer configured to generate a signal indicative of an amount of infrared energy being received by the infrared sensing structure. The cavity captures a portion of the infrared energy received by the infrared sensing structure therein.

A method for manufacturing an infrared sensor in accordance with another exemplary embodiment is proved. The method includes depositing a germanium layer on a silicon substrate. The method further includes depositing a first electrically conductive layer on both the germanium layer and a portion of the silicon substrate. The method further includes depositing a ferroelectric layer on the first electrically conductive layer opposite the germanium layer. The method further includes depositing a second electrically conductive layer on both the ferroelectric layer and a portion of the silicon substrate. The method further includes removing the germanium layer by applying a liquid on the germanium layer that dissolves the germanium layer such that a cavity is formed between the first electrically conductive layer and the silicon substrate. The cavity is configured to capture a portion of infrared energy therein that is received by the first electrically conductive layer, the ferroelectric layer, and the second electrically conductive layer.

An infrared sensor in accordance with another exemplary embodiment is provided. The infrared sensor includes a silicon substrate. The infrared sensor further includes a first electrically conductive layer disposed on a portion of the silicon substrate such that a cavity is formed between a portion of the first electrically conductive layer and the silicon substrate. The infrared sensor further includes a ferroelectric layer disposed on the first electrically conductive layer opposite the cavity. The infrared sensor further includes a second electrically conductive layer disposed on both the ferroelectric layer and another portion of the silicon substrate. The first electrically conductive layer, the ferroelectric layer, and the second electrically conductive layer are configured to generate a signal indicative of an amount of infrared energy being received by the first electrically conductive layer, the ferroelectric layer, and the second electrically conductive layer. The cavity is configured to capture a portion of the infrared energy received by the first electrically conductive layer, the ferroelectric layer and the second electrically conductive layer.

### BRIEF DESCRIPTION OF THE DRAWINGS

Figure 1 is a block diagram of a manufacturing system utilized to manufacture infrared sensors described herein;
Figure 2 is a cross-sectional view of an infrared sensor in accordance with an exemplary embodiment;
Figures 3-4 are flowcharts of a method for manufacturing the infrared sensor of Figure 2 in accordance with another exemplary embodiment;
Figure 5 is a cross-sectional view of an infrared sensor in accordance with another exemplary embodiment;
Figures 6-7 are flowcharts of a method for manufacturing the infrared sensor of Figure 5 in accordance with another exemplary embodiment;
Figure 8 is a cross-sectional view of an infrared sensor in accordance with another exemplary embodiment; and
Figure 9 is a flowchart of a method for manufacturing the infrared sensor of Figure 8 in accordance with another exemplary embodiment.

### DESCRIPTION OF THE PREFERRED EMBODIMENT

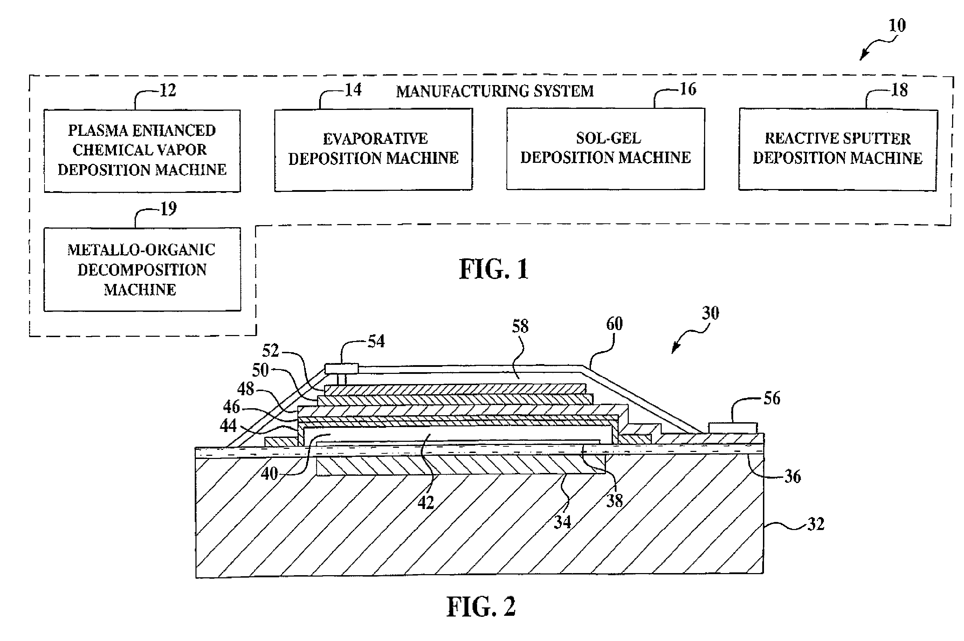

Referring to Figure 1, a manufacturing system 10 for manufacturing the infrared sensors described herein is illustrated. The manufacturing system 10 includes a plasma enhanced chemical vapor deposition machine 12, an evaporative deposition machine 14, a sol-gel deposition machine 16, a reactive sputter deposition machine 18, and a metallo-organic decomposition machine 19.

The plasma enhanced chemical vapor deposition machine 12 is provided to deposit or form a layer of a particular chemical compound on another layer. For example, the machine 12 can deposit an electrically insulative layer such as a low temperature oxide layer on another layer. Further, for example, the machine 12 can deposit a germanium layer, a silicon nitride layer, and an oxynitride layer, on another layer.

The evaporative deposition machine 14 is provided to deposit or form a layer of a particular chemical compound on another layer. For example, the machine 14 can deposit a titanium layer and a platinum layer on another layer.

The sol-gel deposition machine 16 is provided to deposit or form a ferroelectric layer on another layer. The ferroelectric layer can comprise one of a strontium bismuth tantalate layer, a barium strontium titanate layer, a lead zirconate titanate layer, or the like, for example.

The reactive sputter deposition machine 18 is provided to deposit or form a layer of a particular chemical compound on another layer. For example, the machine 18 can deposit on another layer one or more of the following layers: a titanium layer, a platinum layer, and a chrome oxide layer.

The metallo-organic decomposition machine 19 is provided to deposit or form a ferroelectric layer on another layer. The ferroelectric layer can comprise one of a strontium bismuth tantalate layer, a barium strontium titanate layer, a lead zirconate titanate layer, or the like, for example.

Referring to Figure 2, an infrared sensor 30 for detecting infrared energy in accordance with an exemplary embodiment is illustrated. The infrared sensor 30 includes a silicon substrate 32, an on-chip integrated circuit 34, an electrically insulative layer 36, a metal layer 38, a germanium layer 40, a silicon nitride layer 44, a titanium layer 46, a platinum layer 48, a ferroelectric layer 50, a platinum layer 52, aluminum pads 54, 56, an oxynitride layer 58, and a chrome oxide layer 60. It should be noted that during manufacture of the infrared sensor 30, the germanium layer 40 is removed.

The silicon substrate 32 is provided to hold the on-chip integrated circuit 34 and other layers including an infrared sensing structure thereon. The on-chip integrated circuit 34 can be electrically coupled to the aluminum pads 54, 56 and configured to measure a change of an electric charge between aluminum pads 54, 56 which is indicative of a temperature of the infrared sensor 30 and further indicative of an amount of infrared energy being emitted from the environment that is received by the infrared sensor 30.

The electrically insulative layer 36 is provided to electrically insulate the on-chip integrated circuit 34 from the layers disposed on or above the layer 36. The layer 36 is disposed between the silicon substrate 32 and the metal layer 42. In one exemplary embodiment, the layer 36 comprises a low temperature oxide. Of course, in alternative embodiments, the layer 36 can comprise other types of insulative materials known to those skilled in the art.

The metal layer 38 is provided to reflect infrared energy received by the infrared sensor 30 upwardly toward an infrared sensing structure. In one exemplary embodiment, the layer 38 comprises a titanium layer. In another exemplary embodiment, the layer 38 comprises a platinum layer.

The germanium layer 40 is provided to temporarily hold the silicon nitride layer 44 thereon, and to subsequently allow the formation of a cavity 42 in the infrared sensor 30 when the germanium layer 40 is removed or dissolved. The germanium layer 40 is disposed between the metal layer 38 and the silicon nitride layer 44.

The silicon nitride layer 44 is provided hold an infrared sensing structure thereon. The silicon nitride layer 44 is a generally U-shaped structure disposed between the germanium layer 40 and the titanium layer 46.

The titanium layer 46 is provided to bond to the silicon nitride layer 44. The titanium layer 46 is disposed between the silicon nitride layer and the platinum layer 48, and thus the titanium layer 46 promotes an adhesion of the platinum layer 48.

A combination of the platinum layer 48, the ferroelectric layer 50, and the platinum layer 52 comprises an infrared sensing structure that generates an output voltage indicative of a temperature of the infrared sensor 30. The platinum layer 48 is disposed between the titanium layer 46 and the ferroelectric layer 50. The ferroelectric layer 50 is disposed between the platinum layers 48, 52. The ferroelectric layer 50 can comprise one of a strontium bismuth tantalate layer, a barium strontium titanate layer, a lead zirconate titanate layer, or another ferroelectric layer or material known to those skilled in the art.

The aluminum pads 54, 56 are electrically coupled to the platinum layers 52, 48, respectively. The aluminum pads 54, 56 are provided to allow the integrated circuit on the infrared sensor 30 to measure an output voltage of the infrared sensing structure which is indicative of a temperature of the infrared sensor 30.

The oxynitride layer 58 is provided to assist in absorbing infrared energy. In one exemplary embodiment, the layer 58 absorbs infrared energy having a wavelength in a range of 7-12 microns. The oxynitride layer 58 is disposed between the platinum layer 52 and the chrome oxide layer 60.

The chrome oxide 60 is provided to assist in absorbing infrared energy. In one exemplary embodiment, the layer 60 absorbs infrared energy having a wavelength in a range of 7-12 microns. The chrome oxide layer 60 is disposed on the oxynitride layer 58.

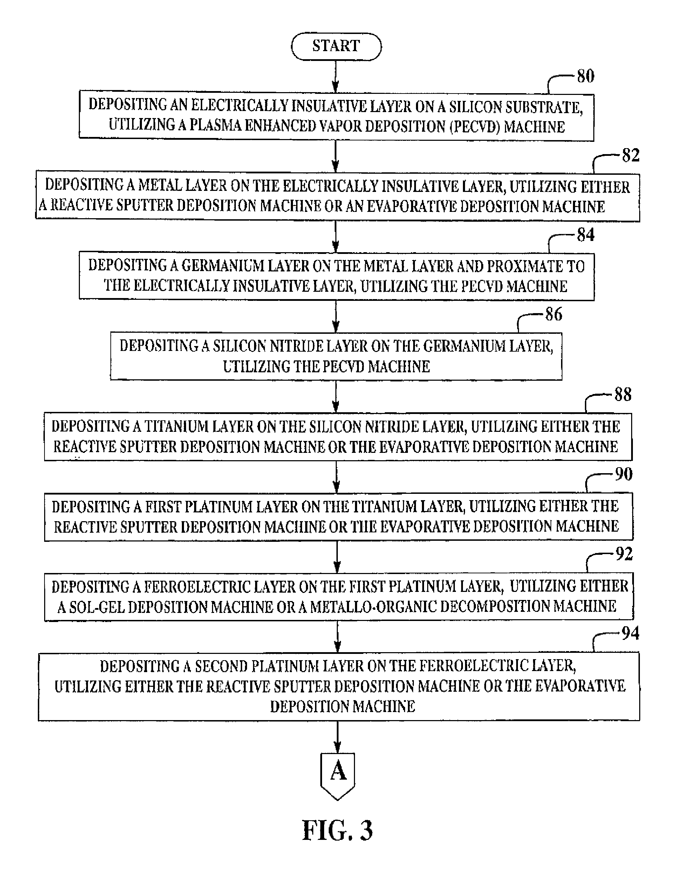

Referring to Figures 3-4, a method for manufacturing the infrared sensor 30 utilizing the manufacturing system 10 will now be explained.

At step 80, the electrically insulative layer 36 is deposited on the silicon substrate 32, utilizing the plasma enhanced chemical vapor deposition machine 12.

At step 82, the metal layer 38 is deposited on the electrically insulative layer 36, utilizing either the reactive sputter deposition machine 28 or the evaporative deposition machine 14.

At step 84, the germanium layer 40 is deposited on the metal layer 38 and proximate to electrically insulative layer, utilizing the PECVD machine 12.

At step 86, the silicon nitride layer 44 is deposited on the germanium layer 40, utilizing the PECVD machine 12.

At step 88, the titanium layer 46 is deposited on the silicon nitride layer 44, utilizing either the reactive sputter deposition machine 18 or the evaporative deposition machine 14.

At step 90, the platinum layer 48 is deposited on the titanium layer 46, utilizing either the reactive sputter deposition machine 18 or the evaporative deposition machine 14.

At step 92, the ferroelectric layer 50 is deposited on the platinum layer 48, utilizing either the sol-gel deposition machine 16 or the metallo-organic decomposition machine 19.

At step 94, the platinum layer 52 is deposited on the ferroelectric layer 50, utilizing either the reactive sputter deposition machine 18 or the evaporative deposition machine 14.

At step 96, the aluminum pad 54 is deposited on a portion of the platinum layer 48, utilizing either the reactive sputter deposition machine 18 or the evaporative deposition machine 14.

At step 98, the aluminum pad 56 is deposited on a portion of the platinum layer 52, utilizing either the reactive sputter deposition machine 18 or the evaporative deposition machine 14.

At step 100, the oxynitride layer 58 is deposited on a portion of the platinum layer 52, utilizing the PECVD machine 12.

At step 102, the chrome oxide layer 60 is deposited on the oxynitride layer 58, utilizing the reactive sputter deposition machine 18.

At step 104, the germanium layer 40 is removed by applying a liquid on the germanium layer 40 that dissolves the germanium layer 40 such that the cavity 42 is formed between the electrically insulative layer 36 and the silicon nitride layer 44. In one exemplary embodiment, the liquid is hydrogen peroxide. The cavity 42 is configured to capture a portion of infrared energy therein that is received by the infrared sensing structure. After step 104, the method is exited.

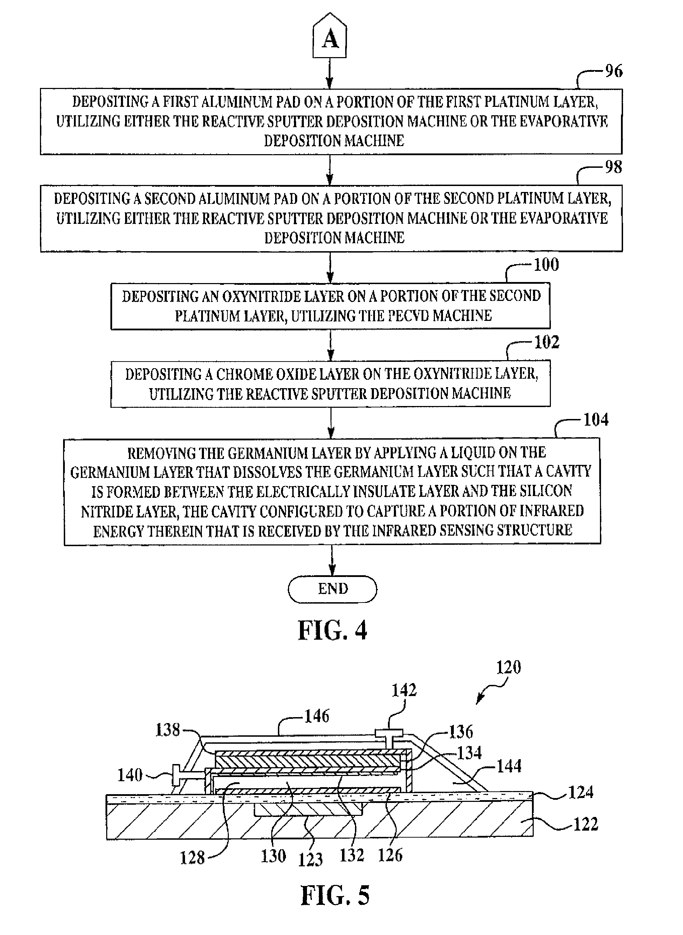

Referring to Figure 5, an infrared sensor 120 for detecting infrared energy in accordance with another exemplary embodiment is illustrated. The infrared sensor 120 includes a silicon substrate 122, an on-chip integrated circuit 123, an electrically insulative layer 124, a metal layer 126, a germanium layer 128, a titanium layer 132, a platinum layer 134, a ferroelectric layer 136, a platinum layer 138, aluminum pads 140, 142, an oxynitride layer 144, and a chrome oxide layer 146. It should be noted that during manufacture of the infrared sensor 120, the germanium layer 128 is removed.

The silicon substrate 122 is provided to hold the on-chip integrated circuit 123 and other layers including an infrared sensing structure thereon. The on-chip integrated circuit 123 can be electrically coupled to the aluminum pads 140, 142 and configured to measure an output voltage between aluminum pads 140, 142 which is indicative of a temperature of the infrared sensor and further indicative of an amount of infrared energy being received by the infrared sensor from the environment.

The electrically insulative layer 124 is provided to electrically insulate the on-chip integrated circuit 123 from the layers disposed on or above the layer 124. The layer 124 is disposed between the silicon substrate 122 and the metal layer 126. In one exemplary embodiment, the layer 124 comprises a low temperature oxide. Of course, in alternative embodiments, the layer 124 can comprise other types of insulative materials known to those skilled in the art.

The metal layer 126 is provided to reflect infrared energy received by the infrared sensor 120 upwardly toward an infrared sensing structure. In one exemplary embodiment, the layer 128 comprises a titanium layer. In another exemplary embodiment, the layer 128 comprises a platinum layer.

The germanium layer 128 is provided to temporarily hold the titanium layer 132 thereon, and to subsequently allow the formation of a cavity 130 in the infrared sensor 120 when the germanium layer 128 is removed or dissolved. The germanium layer 128 is disposed between the metal layer 126 and the titanium layer 132.

The titanium layer 132 is provided to bond to the germanium layer 128. The titanium layer 132 is disposed between the silicon nitride layer and the platinum layer 134.

A combination of the platinum layer 134, the ferroelectric layer 136, and the platinum layer 138 comprises an infrared sensing structure that generates an output voltage indicative of a temperature of the infrared sensor 120. The platinum layer 134 is disposed between the titanium layer 132 and the ferroelectric layer 136. The ferroelectric layer 136 is disposed between the platinum layers 134, 138. The ferroelectric layer 136 can comprise one of a strontium bismuth tantalate layer, a barium strontium titanate layer, a lead zirconate titanate layer, or another ferroelectric layer or material known to those skilled in the art.

The aluminum pads 140, 142 are electrically coupled to the platinum layers 134, 138, respectively. The aluminum pads 140, 142 are provided to allow the integrated circuit on the infrared sensor 120 to measure an output electric charge change of the infrared sensing structure which is indicative of a temperature of the infrared sensor 30.

The oxynitride layer 144 is provided to assist in absorbing infrared energy. In one exemplary embodiment, the layer 144 absorbs infrared energy having a wavelength in a range of 7-12 microns. The oxynitride layer 144 is disposed between the platinum layer 138 and the chrome oxide layer 146.

The chrome oxide layer 146 is provided to assist in absorbing infrared energy. In one exemplary embodiment, the layer 146 absorbs infrared energy having a wavelength in a range of 7-12 microns. The chrome oxide layer 146 is disposed on the oxynitride layer 144.

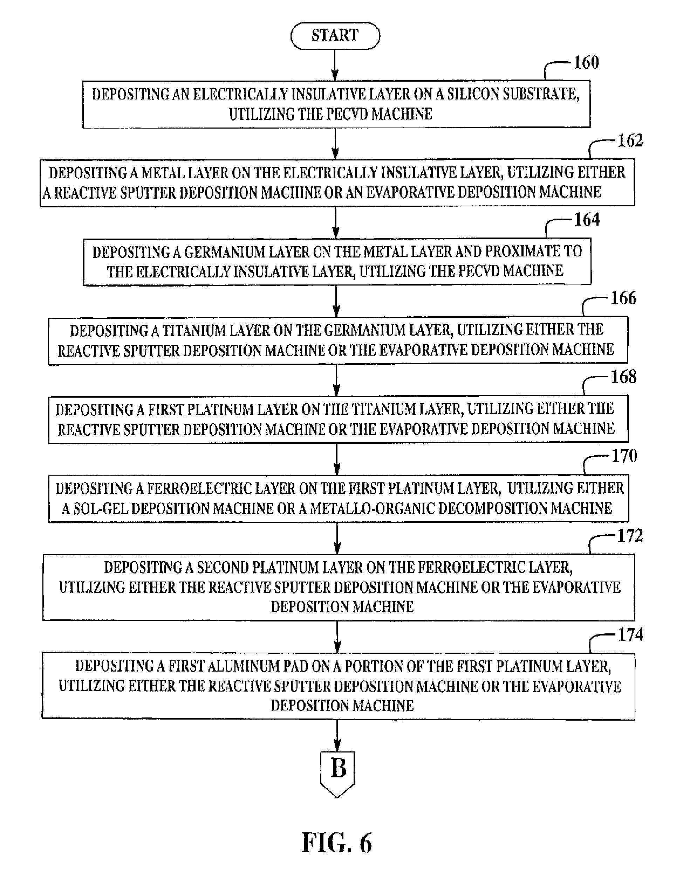

Referring to Figures 6-7, a method for manufacturing the infrared sensor 30 utilizing the manufacturing system 10 will now be explained.

At step 160, the electrically insulative layer 124 is deposited on the silicon substrate 122, utilizing the PECVD machine 12.

At step 162, the metal layer 126 is deposited on the electrically insulative layer 124, utilizing either the reactive sputter deposition machine 18 or the evaporative deposition machine 14.

At step 164, the germanium layer 128 is deposited on the metal layer 126 proximate to the electrically insulative layer 124, utilizing the PECVD machine 12.

At step 166, the titanium layer 132 is deposited on the germanium layer 128, utilizing either the reactive sputter deposition machine 18 or the evaporative deposition machine 14.

At step 168, the platinum layer 134 is deposited on the titanium layer 132, utilizing either the reactive sputter deposition machine 18 or the evaporative deposition machine 14.

At step 170, the ferroelectric layer 136 is deposited on the platinum layer 134, utilizing either the sol-gel deposition machine 16 or the metallo-organic decomposition machine 19.

At step 172, the platinum layer 138 is deposited on the ferroelectric layer 136, utilizing either the reactive sputter deposition machine 18 or the evaporative deposition machine 14.

At step 174, the aluminum pad 140 is deposited on a portion of the platinum layer 138, utilizing either the reactive sputter deposition machine 18 or the evaporative deposition machine 14.

At step 176, the aluminum pad 142 is deposited on a portion of the platinum layer 138, utilizing either the reactive sputter deposition machine 18 or the evaporative deposition machine 14.

At step 178, the oxynitride layer 144 is deposited on a portion of the platinum layer 138, utilizing the PECVD machine 12.

At step 180, the chrome oxide layer 144 is deposited on the oxynitride layer 144, utilizing the reactive sputter deposition machine 18.

At step 182, the germanium layer 128 is removed by applying a liquid on the germanium layer 128 that dissolves the germanium layer 128 such that the cavity 130 is formed between the electrically insulative layer 124 and the titanium layer 132. In one exemplary embodiment, the liquid is hydrogen peroxide. The cavity 130 is configured to capture a portion of infrared energy therein that is received by the infrared sensing structure. After step 182, the method is exited.

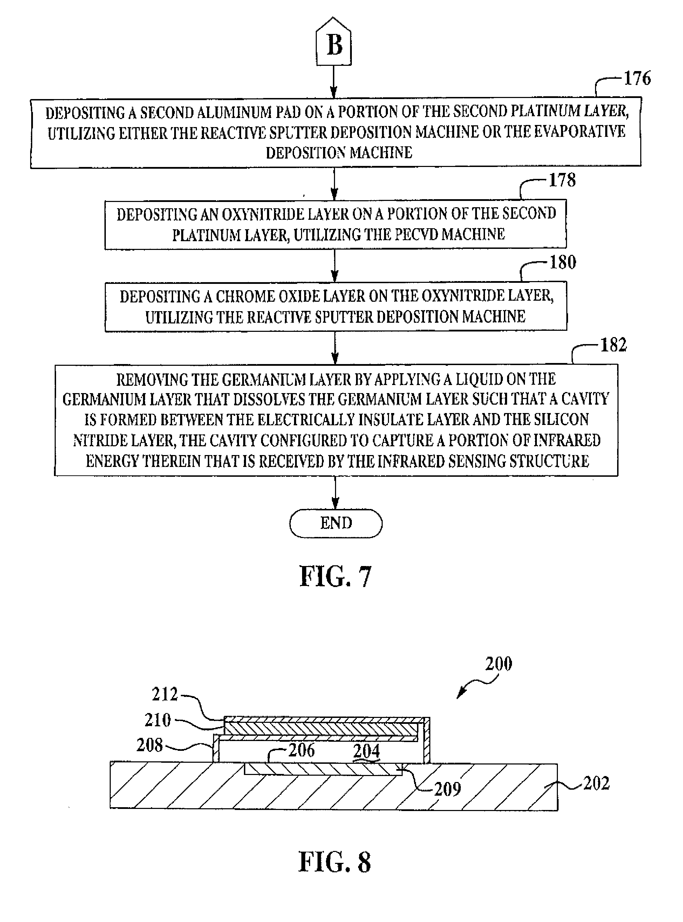

Referring to Figure 8, an infrared sensor 200 for detecting infrared energy in accordance with another exemplary embodiment is illustrated. The infrared sensor 200 includes a silicon substrate 202, a germanium layer 204, a platinum layer 208, a ferroelectric layer 210, and a platinum layer 212. It should be noted that during manufacture of the infrared sensor 200, the germanium layer 204 is removed to form a cavity 206.

The silicon substrate 202 is provided to hold the other layers including an infrared sensing structure thereon. The silicon substrate 202 may have an integrated circuit 209 thereon which is electrically coupled to the electrically conductive layers 208 and 212. In one exemplary embodiment, the layers 208 and 212 comprise indium tin oxide. However, in alternative embodiments, the layers 208 and 212 can comprise any electrically conductive oxide known to those skilled in the art. Further, in other alternative embodiments, the layers 208 and 212 can comprise metal layers, such as platinum layers or titanium layers for example, known to those skilled in the art.

The germanium layer 204 is provided to temporarily hold the electrically conductive layer 208 thereon, and to subsequently allow the formation of the cavity 206 in the infrared sensor 200 when the germanium layer 204 is removed or dissolved. The germanium layer 204 is disposed between the silicon substrate 202 and the electrically conductive layer 208.

A combination of the electrically conductive layer 208, the ferroelectric layer 210, and the electrically conductive layer 212 comprises an infrared sensing structure that generates an output voltage indicative of a temperature of the infrared sensor 200. The electrically conductive layer 208 is disposed between the germanium layer 206 and the ferroelectric layer 210. The ferroelectric layer 210 is disposed between the electrically conductive layers 208, 212. The ferroelectric layer 210 can comprise one of a strontium bismuth tantalate layer, a barium strontium titanate layer, a lead zirconate titanate layer, or another ferroelectric layer or material known to those skilled in the art. The electrically conductive layers 208, 212 may comprise one or more of ruthenium oxide, lanthanum strontium cobalt, lanthanum strontium chromite, or other suitable conductive metal oxides known to those skilled in the art for example.

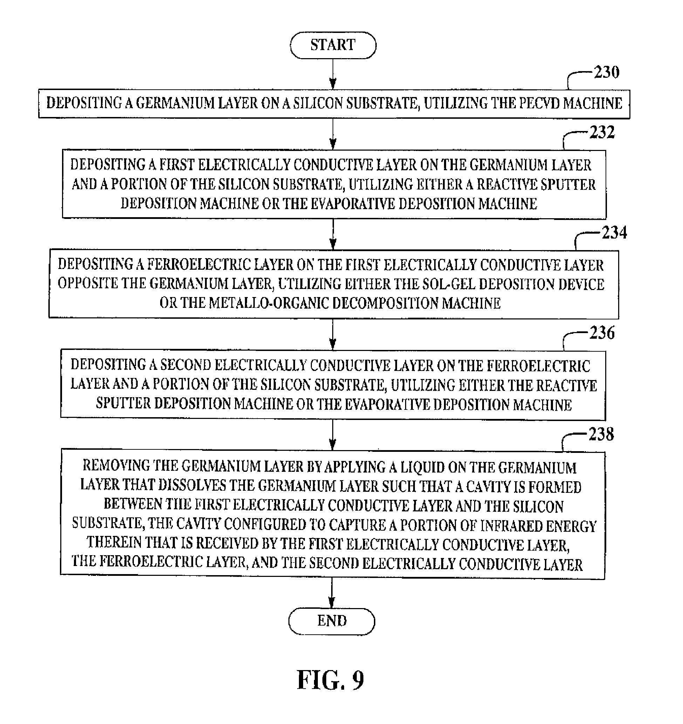

Referring to Figure 9, a method for manufacturing the infrared sensor 200 utilizing the manufacturing system 10 will now be explained.

At step 230, the germanium layer 204 is deposited on the silicon substrate 202, utilizing the PECVD machine 12.

At step 232, the electrically conductive layer 208 is deposited on the germanium layer 204 and a portion of the silicon substrate 202, utilizing either the reactive sputter deposition machine 18 or the evaporative deposition machine 14.

At step 234, the ferro-electric layer 210 is deposited on the electrically conductive layer 208 opposite the germanium layer 204, utilizing either the sol-gel deposition device 16 or the metallo-organic decomposition machine 19.

At step 236, the electrically conductive layer 212 is deposited on the ferro-electric layer 210 and a portion of the silicon substrate 202, utilizing either the reactive sputter deposition machine 18 or the evaporative deposition machine 14.

At step 238, the germanium layer 204 is removed by applying a liquid on the germanium layer 204 that dissolves the germanium layer 204 such that the cavity 206 is formed between the electrically conductive layer 208 and the silicon substrate 202. In one exemplary embodiment, the liquid is hydrogen peroxide. The cavity 206 is configured to capture a portion of infrared energy therein that is received by the electrically conductive layer 212, the ferroelectric layer 210, and the electrically conductive layer 208. After step 236, the method is exited.

The infrared sensors and the methods for manufacturing the infrared sensors represent a substantial improvement over other sensors and methods. In particular, the methods for manufacturing the infrared sensors provide a technical effect of depositing an infrared sensing structure on a silicon substrate and forming a cavity between the infrared sensing structure and the silicon substrate for capturing infrared energy.

While the invention has been described with reference to exemplary embodiments, it will be understood by those skilled in the art that various changes may be made and equivalent elements may be substituted for elements thereof without departing from the scope of the invention. In addition, many modifications may be made to adapt a particular situation or material to the teachings of the invention without departing from the essential scope thereof. Therefore, it is intended that the invention not be limited to the particular embodiments disclosed for carrying out this invention, but that the invention will include all embodiments falling within the scope of the appended claims. Moreover, the use of the terms first, second, etc. do not denote any order or importance, but rather the terms first, second, etc. are used to distinguish one element from another. Further, the use of the terms a, an, etc. do not denote a limitation of quantity, but rather denote the presence of at least one of the referenced item.

## Claims

1. A method for manufacturing an infrared sensor (30), comprising:
depositing an electrically insulative layer (36) on a silicon substrate (32);
depositing a germanium layer (40) proximate to the electrically insulative layer (36);
depositing a silicon nitride layer (44) on a side of the germanium layer (40) opposite the electrically insulative layer (36);
depositing a titanium layer (46) on the silicon nitride layer (44);
disposing an infrared sensing structure on the titanium layer (46); and
removing the germanium layer (40) by applying a liquid on the germanium layer (40) that dissolves the germanium layer (40) such that a cavity (42) is formed between the electrically insulative layer (36) and the silicon nitride layer (44), the cavity (42) configured to capture a portion of infrared energy therein that is received by the infrared sensing structure.

2. The method of claim 1, wherein the infrared sensing structure comprises a first platinum layer (48), a ferroelectric layer (50), and a second platinum layer (52),
wherein disposing the infrared sensing structure on the titanium layer (46), comprises:
depositing the first platinum layer (48) on the titanium layer (46);
depositing the ferroelectric layer (50) on the first platinum layer (48); and
depositing the second platinum layer (52) on the ferroelectric layer (50).

3. The method of claim 1, wherein the ferroelectric layer (50) comprises one of a strontium bismuth tantalate layer, a barium strontium titanate layer, and a lead zirconate titanate layer.

4. The method of claim 2, further comprising:
depositing a first aluminum pad (56) on a portion of the first platinum layer (48); and depositing a second aluminum pad (54) on a portion of the second platinum layer (52).

5. The method of claim 1, further comprising depositing a metal layer (38) on the electrically insulative layer (36) between the electrically insulative layer (36) and at least a portion of the germanium layer (40).

6. The method of claim 5, wherein the metal layer (38) comprises another titanium layer or a platinum layer.

7. The method of claim 1, further comprising:
depositing an oxynitride layer (58) on the infrared sensing structure; and
depositing a chrome oxide layer (60) on the oxynitride layer (58).

8. An infrared sensor (30), comprising:
a silicon substrate (32);
an electrically insulative layer (36) disposed on the silicon substrate (32);
a silicon nitride layer (44) disposed proximate to the electrically insulative layer (36) such that a cavity (42) is formed therebetween;
a titanium layer (46) disposed on a side of the silicon nitride layer (44) opposite the electrically insulative layer (36); and
an infrared sensing structure disposed on the titanium layer (46) configured to generate a signal indicative of an amount of infrared energy being received by the infrared sensing structure, the cavity (42) configured to capture a portion of the infrared energy that is received by the infrared sensing structure.

9. The infrared sensor of claim 8, wherein the infrared sensing structure comprises:
a first platinum layer (48) disposed on the titanium layer (46);
a ferroelectric layer (50) disposed on the first platinum layer (48); and
a second platinum layer (52) disposed on the ferroelectric layer (50).

10. The infrared sensor of claim 9, wherein the ferroelectric layer (50) comprises one of a strontium bismuth tantalate layer, a barium strontium titanate layer, and a lead zirconate titanate layer.

11. The infrared sensor of claim 9, further comprising:
a first aluminum pad (56) disposed on a portion of the first platinum layer (48); and
a second aluminum pad (54) disposed on a portion of the second platinum layer (52).

12. The infrared sensor of claim 8, further comprising a metal layer disposed on the electrically insulative layer between the electrically insulative layer and at least a portion of the germanium layer.

13. The infrared sensor of claim 12, wherein the metal layer (38) comprises another titanium layer or a platinum layer.

14. The infrared sensor of claim 8, further comprising:
an oxynitride layer (58) disposed on the infrared sensing structure; and
a chrome oxide layer (60) disposed on the oxynitride layer (58).

15. A method for manufacturing an infrared sensor (120), comprising:
depositing an electrically insulative layer (124) on a silicon substrate (122);
depositing a germanium layer (128) proximate to the electrically insulative layer (124);
depositing a titanium (132) layer on the germanium layer (128);
disposing an infrared sensing structure on the titanium layer (132); and
removing the germanium layer (128) by applying a liquid on the germanium layer (128) that dissolves the germanium layer (128) such that a cavity (130) is formed between the electrically insulative layer (124) and the titanium layer (132), the cavity (130) configured to capture a portion of infrared energy therein that is received by the infrared sensing structure.

16. The method of claim 15, wherein the infrared sensing structure comprises a first platinum layer (134), a ferroelectric layer (136), and a second platinum layer (138),
wherein disposing the infrared sensing structure on the titanium layer (132) comprises:
depositing the first platinum layer (134) on the titanium layer (132);
depositing the ferroelectric layer (136) on the first platinum layer (134); and
depositing the second platinum layer (138) on the ferroelectric layer (136).

17. An infrared sensor (120), comprising:
a silicon substrate (122);
an electrically insulative layer (124) disposed on the silicon substrate (122);
a titanium layer (132) disposed proximate to the electrically insulative layer (124) such that a cavity (130) is formed therebetween; and
an infrared sensing structure disposed on the titanium layer (132) configured to generate a signal indicative of an amount of infrared energy being received by the infrared sensing structure, the cavity (130) capturing a portion of the infrared energy received by the infrared sensing structure therein.

18. The infrared sensor of claim 17, wherein the infrared sensing structure comprises:
a first platinum layer (134) disposed on the titanium layer (132);
a ferroelectric layer (136) disposed on the first platinum layer (134); and
a second platinum layer (138) disposed on the ferroelectric layer (136).

19. A method for manufacturing an infrared sensor (200), comprising:
depositing a germanium layer (204) on a silicon substrate (202);
depositing a first electrically conductive layer (208) on both the germanium layer (204) and a portion of the silicon substrate (202);
depositing a ferroelectric layer (210) on the first electrically conductive layer (208) opposite the germanium layer (204);
depositing a second electrically conductive layer (212) on both the ferroelectric layer (210) and a portion of the silicon substrate (202); and
removing the germanium layer (204) by applying a liquid on the germanium layer (204) that dissolves the germanium layer (204) such that a cavity (206) is formed between the first electrically conductive layer (208) and the silicon substrate (202), the cavity (206) configured to capture a portion of infrared energy therein that is received by the first electrically conductive layer (208), the ferroelectric layer (210), and the second electrically conductive layer (212).

20. An infrared sensor (200), comprising:
a silicon substrate (202);
a first electrically conductive layer (208) disposed on a portion of the silicon substrate (202) such that a cavity (206) is formed between a portion of the first electrically conductive layer (208) and the silicon substrate (202);
a ferroelectric layer (210) disposed on the first electrically conductive layer (208) opposite the cavity (206); and
a second electrically conductive layer (212) disposed on both the ferroelectric layer (210) and another portion of the silicon substrate (202); the first electrically conductive layer (208), the ferroelectric layer (210), and the second electrically conductive layer (212) being configured to generate a signal indicative of an amount of infrared energy being received by the first electrically conductive layer (208), the ferroelectric layer (210), and the second electrically conductive layer (212); the cavity (206) being configured to capture a portion of the infrared energy received by the first electrically conductive layer (208), the ferroelectric layer (210) and the second electrically conductive layer (212).
